# EUROPÄISCHE PATENTANMELDUNG

(11) **EP 2 081 233 A1**
(43) Veröffentlichungstag der Anmeldung: **22.07.2009**
(21) Anmeldenummer: 08020120.5
(22) Anmeldetag: 19.11.2008
(51) Int. Cl.: H01L 29/861, H01L 21/329, H01L 29/06, H01L 29/417, H01L 29/40

(54) **Leistungsdiode mit grabenförmigen Anodenkontaktbereich**

(30) Priorität: 21.12.2007 DE 102007062306
(71) Anmelder: SEMIKRON Elektronik GmbH & Co. KG, 90431 Nürnberg (DE)
(72) Erfinder: König, Bernhard, 90765 Fürth (DE)

(57) **Zusammenfassung**

Die Erfindung beschreibt ein Leistungshalbleiterbauelement und zwei Herstellungsverfahren hierzu. Das Bauelement weist einen Halbleitergrundkörper (2,4) erster Dotierung und einen pn- Übergang (126) auf, der durch einen Kontaktbereich (12) zweiter Dotierung mit einem Dotierungsprofil (120) in dem Grundkörper ausgebildet ist. Hierbei ist der zweite Kontaktbereich an einer zweiten Oberfläche (10) des Grundkörpers angeordnet und erstreckt sich in das Volumen des Grundkörpers hinein. Hierzu weist der Grundkörper eine grabenförmige Ausnehmung (24) mit einer Randfläche (124) und einer Grundfläche (122) auf, wobei diese Grundfläche als zweite Teilfläche der zweiten Oberfläche ausgebildet ist und wobei der zweite Kontaktbereich sich von der Grundfläche über die Randfläche bis an eine erste Teilfläche erstreckt. Weiterhin weist der pn- Übergang eine Krümmung (128) benachbart zur Randfläche auf.

## Beschreibung

Die Erfindung beschreibt ein Leistungshalbleiterbauelement mit mindestens einem pn- Übergang, vorzugsweise eine Leistungsdiode mit einer Sperrspannungsfestigkeit von mindestens 600V, für Anwendungen in Stromrichtern der Leistungsklasse. Eine wesentliche Anforderung hieraus für derartige Leistungshalbleiterbauelemente sind möglichst geringe Schaltverluste. Gemäß dem Stand der Technik sind zur Erzielung dieser Anforderung zwei Lösungswege besonders bevorzugt.

Beispielhaft aus der Druckschrift DE 43 37 329 C2 ist ein Leistungshalbleiterbauelement, hier eine Leistungsdiode, bekannt mit einem pn-Übergang, wobei im Halbleiterkörper Rekombinationszentren mittels Bestrahlen mit hochernergetischen Teilchen erzeugt werden. Hierzu finden sowohl Elektronen als auch Heliumkerne Anwendung. Hierdurch wird eine schnelle Leistungsdiode ausgebildet, die eine hohe Spannungsfestigkeit und weitere positive Eigenschaften in der Kombination mit Leistungstransistoren aufweist.

Nachteilig an einer Ausbildung einer Leistungsdiode gemäß obiger Druckschrift ist, dass durch die Bestrahlung, beispielhaft mit Heliumkernen, Defekte im Halbleiterkörper erzeugt werden, die durch Ladungsträgererzeugung im Blockierzustand zu höheren Sperrströmen führen. Diese Auswirkung der Implantation kann allerdings in einem weiteren Prozessschritt teilweise kompensiert werden.

Gemäß dem Stand der Technik ist es alternativ bekannt in einem Halbleiterköper erster Dotierung einen Bereich zweiter Dotierung mit geringer Konzentration auszubilden. Der so entstehende pn- Übergang verläuft parallel zur Oberfläche und weist am Randbereich des Dotierungsgebiets eine starke Krümmung des pn- Übergangs auf bevor dieser die Oberfläche erreicht. Nachteilig hierbei ist, eine geringe Spannungsfestigkeit des Leistungshalbleiterbauelements aufgrund der geringen Eindringtiefe der zweiten Dotierung. Zur Kompensation dieses Nachteils ist eine aufwändige Ausgestaltung des Randbereichs jenseits der zweiten Dotierung notwendig.

Der Erfindung liegt die Aufgabe zugrunde ein Leistungshalbleiterbauelement mit geringen Schaltverlusten bei gleichzeitiger hoher Spannungsfestigkeit sowie zugehörige Herstellungsverfahren vorzustellen.

Die Aufgabe wird erfindungsgemäß gelöst, durch die Maßnahmen der Ansprüche 1, 6 und 9. Bevorzugte Ausführungsformen sind in den Unteransprüchen beschrieben.

Der erfinderische Gedanke geht aus von einem Leistungshalbleiterbauelement mit einem Halbleitergrundkörper erster, vorzugsweise n- Dotierung mit einem ersten Kontaktbereich. Zur Ausbildung mindestens eines pn- Übergangs ist in diesem Grundkörper mindestens ein Bereich einer zweiten, vorzugsweise p- Dotierung angeordnet, der im Folgenden als zweiter Kontaktbereich bezeichnet wird. Da dieser Bereich zweiter Dotierung vorzugsweise mittels eines Diffusionsprozesses ausgebildet ist, weist er keine homogene Dotierung sondern ein Dotierungsprofil mit abnehmender Konzentration ausgehend von der Einbringfläche des Dotanten aus auf.

Weiterhin kann es bevorzugt sein, wenn das erfindungsgemäße Leistungshalbleiterbauelement eine Mehrzahl von im Randbereich des Leistungshalbleiterbauelements angeordneten Feldringen aufweist. Diese Feldringe sind ebenfalls als Bereiche zweiter Dotierung und ebenfalls mit einem Dotierungsprofil ausgebildet und umschließen den zweiten Kontaktbereich vorzugsweise konzentrisch. Sowohl der zweite Kontaktbereich wie auch die Feldringe sind an einer zweiten Oberfläche des Grundkörpers angeordnet und erstrecken sich wie beschrieben in das Volumen des Grundkörpers hinein. Alternativ zur Gestaltung des Randbereichs mit Feldringen sind auch weitere Alternativen, wie beispielhaft VLD (variation in lateral doping) gemäß dem Stand der Technik bekannt.

Erfindungsgemäß weißt der Grundkörper im zweiten Kontaktbereich eine grabenförmige Ausnehmung auf, die begrenzt wird durch eine Rand- und eine Grundfläche. Hierbei ist diese Grundfläche als zweite Teilfläche der zweiten Oberfläche des Leistungshalbleiterbauelements ausgebildet und parallel zu einer ersten Teilfläche im Bereich der optionalen Feldringe angeordnet. Der zweite Kontaktbereich erstreckt sich somit von der zweiten Teilfläche über die Randfläche bis an die erste Teilfläche heran. Das beschriebene Leistungshalbleiterbauelement ist ein Volumenbauelemente bei dem der Laststromfluss zwischen den beiden Oberflächen statt findet.

Es kann bei der erfindungsgemäßen Ausgestaltung des Halbleiterbauelements bevorzugt sein, wenn die Randfläche eine Krümmung aufweist, die parallel der Krümmung des pn- Übergangs folgt. Alternativ kann die Randfläche senkrecht oder mit einer Steigung unter einem Winkel von maximal 45 Grad zur Grundfläche ausgebildet sein, wobei die Randfläche in einem Bereich auf die Grundfläche trifft in dem der pn-Übergang parallel zur zweiten Oberfläche verläuft.

Ein erstes erfinderische Verfahren zur Herstellungen eines oben genannten Leistungshalbleiterbauelements umfasst folgende wesentliche Verfahrensschritte:
● Maskierung einer zweiten Oberfläche eines eine erste Dotierung aufweisenden Halbleitergrundkörpers, gemäß dem Stand der Technik. An der ersten, der zweiten gegenüberliegenden, Oberfläche befindet sich ein erster Kontaktbereich.
● Erzeugung von Dotierungsprofilen zweiter Dotierung ausgehend von der zweiten Oberfläche in einem ersten, die spätere erste Teilfläche der Oberfläche bildenden, Teilabschnitt und in einem zweiten Teilabschnitt, wodurch sowohl die Feldringe als auch der zweiter Kontaktbereich erzeugt werden. Vorzugsweise werden die beiden Verfahrensschritte gleichzeitig ausgeführt, wodurch beide Dotierungsprofile in ihrem Konzentrationsverlauf identisch ausgebildet werden.
● Ausbildung eines Grabens im Bereich der zweiten Teilfläche der Oberfläche zur Erzeugung der Grund- und Randfläche des zweiten Kontaktbereichs. Hierzu ist es bevorzugt den nicht zu entfernenden Bereich zu maskieren und anschließend mittels eines Naß- und/oder Trockenätzverfahrens den Graben auszubilden. Die Tiefenausdehnung des Grabens beträgt zwischen 50 von 100 und 90 von 100 der Eindringtiefe der zweiten Dotierung, der Lage des pn-Übergangs. Die laterale Ausdehnung des Grabens beträgt mindestens das zehnfache der Tiefenausdehnung.
● Vollständige oder teilweise Passivierung der ersten Teilfläche.
● Metallisierung des zweiten Kontaktbereichs zur Ausbildung einer Kontaktfläche für eine elektrisch leitende Verbindung. Hierbei kann es bevorzugt sein gleichzeitig mit der Metallisierung des zweiten Kontaktbereichs im Bereich der Feldringe diesen jeweils zugeordnete metallische Feldplatten zu erzeugen.

Ein zweites, alternatives, Verfahren zur Herstellungen eines oben genannten Leistungshalbleiterbauelements umfasst folgende wesentliche Verfahrensschritte:
● Maskierung einer Oberfläche eines eine erste Dotierung aufweisenden Halbleitergrundkörpers, gemäß dem Stand der Technik.
● Ausbildung eines Grabens im Bereich der zweiten Teilfläche der zweiten Oberfläche dem Bereich des späteren zweiten Kontaktbereichs. Hierbei ist es bevorzugt diesen Graben mittels bekannter Naß- und/oder Trockenätzverfahren auszubilden.
● Erzeugung eines Dotierungsprofils zweiter Dotierung mittels Ionenimplantation ausgehend von der zweiten Oberfläche in einem, die spätere zweite Teilfläche bildenden, Teilabschnitt.
● Vollständige oder teilweise Passivierung der ersten Teilfläche.
● Metallisierung (18) des zweiten Kontaktbereichs (12) zur Ausbildung einer Kontaktfläche für eine elektrisch leitende Verbindung.

Wesentlich bei beiden Verfahren ist, dass die Krümmung des pn- Übergangs wesentlich geringer ausgebildet ist im Vergleich zum Stand der Technik. Hierdurch wird die Spannungsfestigkeit des Leistungshalbleiterbauelement wesentlich erhöht und die Gestaltung des Randbereichs, beispielhaft mittels Feldringen weniger erfordert ebenfalls weniger Aufwand.

Die erfinderische Lösung wird an Hand der Ausführungsbeispiele der Fig. 1 bis 5 weiter erläutert.

Fig. 1 zeigt den Grundkörper eines erfindungsgemäßen Leistungshalbleiterbauelements.

Fig. 2 zeigt den Teilschritt zur Ausbildung der zweiten Dotierung des ersten erfindungsgemäßen Verfahrens.

Fig. 3 zeigt den Teilschritt nach Ausbildung der zweiten Dotierung des ersten erfindungsgemäßen Verfahrens.

Fig. 4 zeigt in zwei Varianten den Teilschritt nach Ausbildung des Grabens im Rahmen des ersten erfindungsgemäßen Verfahrens.

Fig. 5 zeigt in zwei Varianten ein erfindungsgemäßes Leistungshalbleiterbauelement.

Fig. 6 zeigt den Teilschritt zur Ausbildung des Grabens und der zweiten Dotierung mittels des zweiten erfindungsgemäßen Verfahrens.

Fig. 7 zeigt ein Leistungshalbleiterbauelement ausgebildet gemäß dem zweiten erfindungsgemäßen Verfahren.

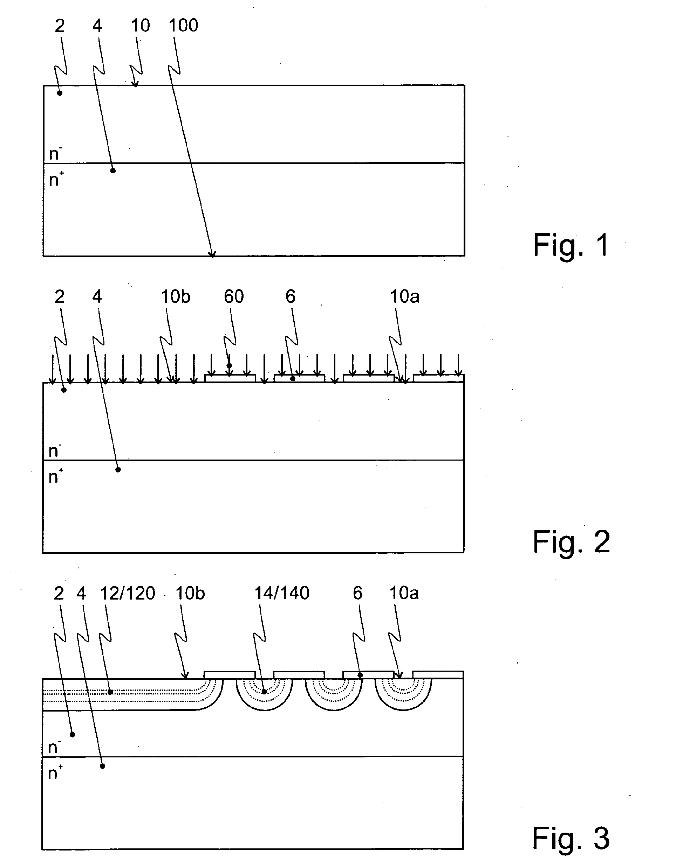

Fig. 1 zeigt einen nicht maßstäblichen Ausschnitt des Grundkörpers (2, 4) eines erfindungsgemäßen Leistungshalbleiterbauelements am Beispiel einer Leistungsdiode für eine Sperrspannung von 1200V. Dieses Beispiel wird grundsätzlich auch für die folgenden Figuren beibehalten. Der Halbleitergrundkörper weist hierbei eine n-Dotierung mit zwei Konzentrationen auf. An der zweiten Oberfläche (10) des Grundkörpers schließt sich ein schwach dotierter Bereich (2) an, während sich an der zweiten Oberfläche (100) ein stark dotierter Bereich (4) anschließt. Die Grenze der beiden Dotierungen verläuft im Inneren des Grundkörpers parallel zu den Oberflächen (10, 100).

Fig. 2 zeigt den Teilschritt zur Ausbildung der zweiten Dotierung des erfindungsgemäßen Verfahrens. Gemäß dem Stand der Technik werden hier verschiedene Bereiche zur Vorbereitung des selektiven Dotierens maskiert (6). Im Bereich der ersten Teilfläche (10a) werden Feldringe, im Bereich der zweiten Teilfläche (10b) wird der zweite Kontaktbereich entstehen. Die Dotierung mittels Diffusion (60) erfolgt hierbei gemäß dem Stand der Technik aus Richtung der zweiten Oberfläche (10).

Fig. 3 zeigt den Teilschritt nach Ausbildung der zweiten, hier p- Dotierung (12, 14) des erfindungsgemäßen Verfahrens. Weiterhin dargestellt ist der Verlauf des Dotierungsprofils (120, 140), also die Abnahme der Konzentration an p- Dotanten mit der Eindringtiefe. Es ist ersichtlich, dass die p- Dotanten nicht nur senkrecht zur Oberfläche (10) in den Halbleitergrundkörper (2, 4) eindringen, sondern auch längs der Oberfläche eindringen und bei genügen kleiner Öffnung der Maskierung (6) annähernd halbkreisförmige Bereiche ausbilden. Dies gilt in analoger Weise auch für die Ausbildung des zweiten Kontaktbereichs, der sich auch lateral in Richtung des ersten Feldrings erstreckt, wobei auch hier die Konzentration an p- Dotanten mit der Tiefe abnimmt.

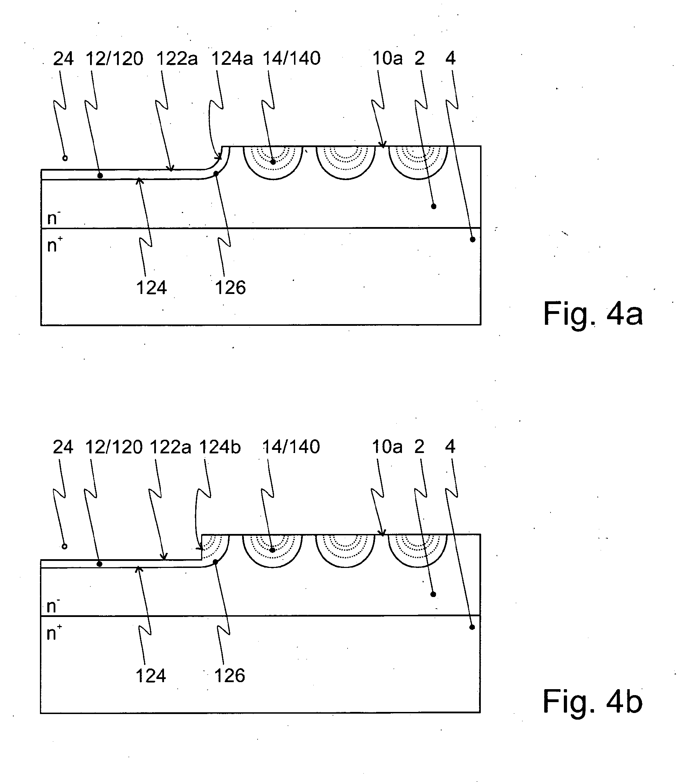

Fig. 4 zeigt in zwei Varianten den Teilschritt nach Ausbildung des Grabens im Rahmen des erfindungsgemäßen Verfahrens. Fig. 4a zeigt hierbei eine erste Variante, wobei der Ätzabtrag zur Ausbildung des Grabens durch geeignete Maskierung und ein geeignetes Ätzmedium im Wesentlichen entlang einer Konzentrationslinie der p-Dotierung (120) erfolgt. Somit entsteht ein schwach dotierter zweiter Kontaktbereich (12) mit einer Grundfläche (122a) und einer stetig daran anschließenden Randfläche (124a), die annähernd im rechten Winkel an der ersten Teilfläche (10a) der Oberfläche endet. Die Dotierung dieses zweiten Kontaktbereichs (12) ist somit flach im Volumen ausgebildet und bezüglich der Konzentration homogen an der gesamten Oberfläche (10b).

Fig. 4b zeigt hierbei eine zweite Variante, wobei der Ätzabtrag durch geeignete Maskierung und ein geeignetes Ätzmedium im Wesentlichen senkrecht zur Oberfläche (10) erfolgt. Hierbei ist zu beachten, dass die Randfläche (124b) an einer Stelle auf die Grundfläche (122b) trifft, an der die Konzentrationslinie des Dotierungsprofils (120) parallel zur Grundfläche (122b) verläuft. Somit ist sicher gestellt, dass nach der Ausbildung des Grabens die verbleibende Konzentration im Bereiche des Übergangs von der Grund- (122b) zur Randfläche (124b) nicht geringer ist als unter einem anderen Abschnitt der Grundfläche (122b). Das Dotierungsprofil (120) der Randfläche (124b) ist somit in der Nähe der ersten Teilfläche (10a) tief ausgebildet und im Wesentlichen identisch demjenigen Dotierungsprofil (140) eines halben Dotierungsprofils eines Feldrings (14).

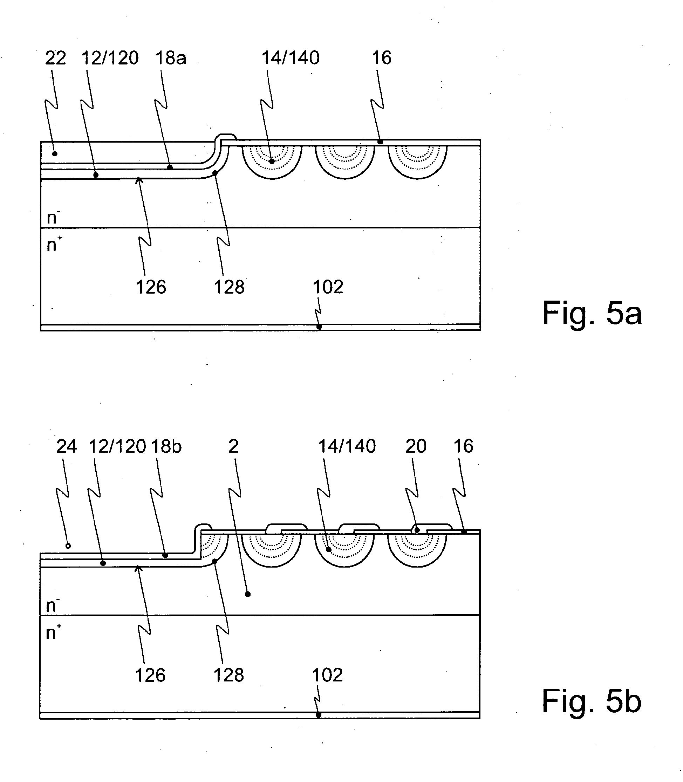

Fig. 5 zeigt in zwei Varianten ein erfindungsgemäßes Leistungshalbleiterbauelement. Fig. 5a zeigt hierbei die erste Variante gebildet gemäß Fig. 4a, wobei hier die erste Teilfläche (10a) oberhalb der Feldringe (14) vollständig mit einer Passivierungsschicht (16) bedeckt ist. Weiterhin wird vor der nachfolgenden Metallisierung (18) des zweiten Kontaktbereichs (12) in diesem Bereich noch ein oberflächennaher Bereich zweiter Dotierung hoher Konzentration erzeugt um einen Ohmschen Kontakt zur Metallisierung auszubilden.

Weiterhin ist der zweite Kontaktbereich (12), also die Grund- (122a) und Randfläche (124b) mit einer Kontaktmetallisierung (18a) versehen, die vorzugsweise auch die Passivierung (16) der ersten Teilfläche (10a) geringfügig überdeckt.

Es kann weiterhin bevorzugt sein den gesamten Graben mit einer Metallschicht (22) zu verfüllen um eine im Wesentlichen plane Oberfläche des Leistungshalbleiterbauelements zu erhalten.

Fig. 5b zeigt hierbei die zweite Variante gebildet gemäß Fig. 4b, wobei hier die erste Teilfläche (10a) oberhalb der Feldringe (14) nicht vollständig mit einer Passivierungsschicht (20) bedeckt ist. Die Freisparungen befinden sich im Bereich der Feldringe (14) und dienen der elektrischen Kontaktierung eines Feldrings (14) mit jeweils einer, diesem zugeordneten, Feldplatte (20). In beiden Varianten gemäß Fig. 5a und 5b ist jeweils auf der zweiten Oberfläche (100) eine Metallisierung (102) dieser dargestellt, die beispielhaft der Lötverbindung mit einem Substrat dient.

Typische Größenordnung für eine Leistungsdiode mit einer bevorzugten Grundfläche im Bereich zwischen 10mm² und 100mm² und einer Sperrspannung von 1200V sind hier die Folgenden:
- Die Dicke der Leistungsdiode beträgt zwischen 100µm und 450µm.
- Der pn- Übergang (126), also die Eindringtiefe der zweiten, hier der p- Dotierung (120, 140) beträgt zwischen 10µm und 30µm.
- Die Tiefenausdehnung des Grabens beträgt maximal 90 von 100 und minimal 50 von 100 der Eindringtiefe der zweiten Dotierung. Bei einer Eindringtiefe von 20µm beträgt die Tiefe des Grabens somit zwischen 10µm und 18µm.
- Der Bereich zweiter Dotierung des zweiten Kontaktbereichs (12) weist an der Oberfläche eine bevorzugte Konzentration von 10¹⁵ bis 10¹⁶ cm⁻³ auf.
- Der oberflächennahe weitere Bereich zweiter Dotierung der Kontaktfläche für den ohmschen Kontakt zur Metallisierung weist ein bevorzugte Konzentration von 10¹⁸ bis 10²⁰ cm⁻³ auf.

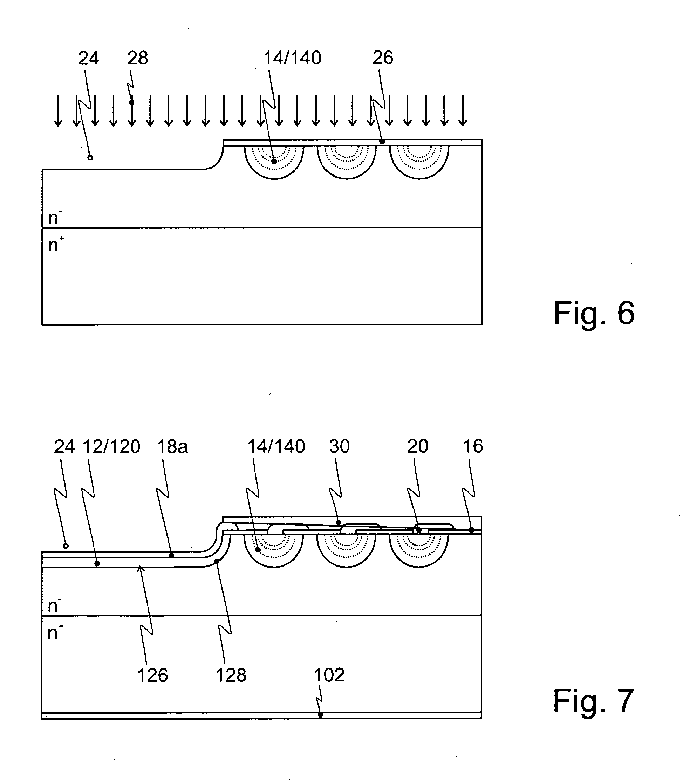

Fig. 6 zeigt den Teilschritt zur Ausbildung des Grabens (24) und des zweiten Kontaktbereichs (12) gemäß dem zweiten erfindungsgemäßen Verfahren. Basierend auf einem Grundkörper (2, 4) gemäß Fig. 1 werden in einem ersten wesentlichen Schritt die für höhere Sperrspannung notwendigen Feldringe (14) ausgebildet. Anschließend wird der Bereich (26) der nicht zur Ausbildung des zweiten Kontaktbereichs (12) dient maskiert und ein Graben (24) ausgehend von der zweiten Oberfläche (10) aus ausgebildet. In einem nächsten Schritt erfolgt die lonenimplantation (28) aus Richtung der zweiten Oberfläche (10). Vorteilhafterweise schließt sich an die lonenimplantation noch ein Ausheilschritt zur Beseitigung von während der Implantation entstandener Kristalldefekte an.

Fig. 7 zeigt ein Leistungshalbleiterbauelement ausgebildet gemäß dem zweiten erfindungsgemäßen Verfahren. Der zweite Kontaktbereich (12) weist hier ein mittels lonenimplantation (28) ausgebildetes Dotierungsprofil (120) auf, wobei auch hier die Krümmung (128) des pn- Übergangs (126) groß ausgebildet ist im Vergleich zum Stand der Technik. Ebenfalls dargestellt sind Feldplatten (20), eine Metallisierung (102) der ersten Oberfläche (100) und eine Metallisierung (18a) des zweiten Kontaktbereichs (12). Vorteilhafterweise ist noch eine Sekundärpassivierung (30) gemäß dem Stand der Technik auf der ersten Teilfläche angeordnet.

## Patentansprüche

1. Leistungshalbleiterbauelement mit einem Halbleitergrundkörper (2, 4) erster Dotierung, einem in diesem Grundkörper ausgebildeten und mit dem Bereich erster Dotierung einen pn- Übergang (126) ausbildenden zweiter Kontaktbereich (12) zweiter Dotierung mit einem Dotierungsprofil (120), wobei der zweite Kontaktbereich (12) an einer zweiten Oberfläche (10) des Grundkörpers angeordnet sind und sich in das Volumen des Grundkörpers hinein erstrecken, und wobei der Grundkörper (2, 4) für diesen zweiten Kontaktbereich (12) eine grabenförmige Ausnehmung (24) mit einer Randfläche (124) und einer Grundfläche (122) aufweist, wobei diese Grundfläche (122) als zweite Teilfläche der zweiten Oberfläche (10) ausgebildet ist, wobei der zweite Kontaktbereich (12) sich von der Grundfläche (122) über die Randfläche (124) bis an eine erste Teilfläche (10a) erstreckt und wobei der pn- Übergang (126) eine Krümmung (128) benachbart zur Randfläche (124) aufweist.

2. Leistungshalbleiterbauelement nach Anspruch 1,
wobei im Randbereich des Leistungshalbleiterbauelements eine Mehrzahl von ebenfalls in dem Grundkörper (2, 4) angeordneter Feldringen (14) zweiter Dotierung ausgebildet sind und diese Feldringe (14) an der ersten Teilfläche (10a) der zweiten Oberfläche (10) des Grundkörpers angeordnet sind und sich in das Volumen des Grundkörpers hinein erstrecken.

3. Leistungshalbleiterbauelement nach Anspruch 2
wobei im Bereiche der Feldringe (14) die Passivierung (16) der ersten Teilfläche (10a) unterbrochen ist und zusätzlich eine Mehrzahl von Feldplatten (20) in leitendem Kontakt mit einem jeweils zugeordneten Feldring (14) aufweist.

4. Leistungshalbleiterbauelement nach Anspruch 1,
wobei die Randfläche (124a) eine Krümmung aufweist, die parallel der Krümmung des pn- Übergangs folgt oder die Randfläche (124b) senkrecht zur Grundfläche (122b) ausgebildet, wobei die Randfläche (124b) in einem Bereich auf die Grundfläche (122b) trifft in dem der pn- Übergang parallel zur zweiten Oberfläche verläuft.

5. Leistungshalbleiterbauelement nach Anspruch 4,
wobei der zweite Kontaktbereich (12) durch eine Kontaktmetallisierung (18) und die erste Teilfläche (10a) durch eine Passivierung (16) bedeckt sind.

6. Verfahren zur Herstellungen eines Leistungshalbleiterbauelements nach einem der Ansprüche 1 bis 5,
**gekennzeichnet durch** die Verfahrensschritte:
● Maskierung (6) einer Oberfläche (10) eines eine erste Dotierung aufweisenden Halbleitergrundkörpers (2, 4);
● Erzeugung von Dotierungsprofilen (120, 140) zweiter Dotierung ausgehend von der zweiten Oberfläche (10) in einem ersten, die spätere erste Teilfläche bildenden, Teilabschnitt und in einem zweiten Teilabschnitt, wodurch die Feldringe (14) und der zweite Kontaktbereich (12) erzeugt werden;
● Ausbildung eines Grabens im Bereich der zweiten Teilfläche (10b) der Oberfläche (10) zur Erzeugung der Grund- (122) und Randfläche (124) des zweiter Kontaktbereichs (12) mit einer Tiefenausdehnung des Grabens, die zwischen 50 von 100 und 90 von 100 der Eindringtiefe der zweiten Dotierung beträgt und einer lateralen Ausdehnung des Grabens, mindestens das zehnfache der Tiefenausdehnung beträgt;
● Vollständige oder teilweise Passivierung (16) der ersten Teilfläche (10a);
● Metallisierung (18) des zweiten Kontaktbereichs (12) zur Ausbildung einer Kontaktfläche für eine elektrisch leitenden Verbindung.

7. Verfahren nach Anspruch 6,
wobei die Erzeugung der Dotierungsprofile (120, 140) zweiter Dotierung für den zweiten Kontaktbereich (12) und die Feldringe (14) gleichzeitig erfolgt.

8. Verfahren nach Anspruch 6,
wobei gleichzeitig mit der Metallisierung (18) des zweiten Kontaktbereichs (12) im Bereich der Feldringe (14) diesen zugeordnete metallische Feldplatten (20) erzeugt werden.

9. Verfahren zur Herstellungen eines Leistungshalbleiterbauelements nach einem der Ansprüche 1 bis 5,
**gekennzeichnet durch** die Verfahrensschritte:
● Maskierung (26) einer Oberfläche (10) eines eine erste Dotierung aufweisenden Halbleitergrundkörpers (2, 4);
● Ausbildung eines Grabens im Bereich der zweiten Teilfläche (10b) der zweiten Oberfläche (10);
● Erzeugung eines Dotierungsprofils (120) zweiter Dotierung mittels lonenimplantation ausgehend von der zweiten Oberfläche (10) in einem ersten, die spätere zweite Teilfläche bildenden, Teilabschnitt;
● Vollständige oder teilweise Passivierung (16) der ersten Teilfläche (10a);
● Metallisierung (18) des zweiten Kontaktbereichs (12) zur Ausbildung einer Kontaktfläche für eine elektrisch leitende Verbindung.

10. Verfahren nach Anspruch 6 oder 9,
wobei vor der Metallisierung (18) des zweiten Kontaktbereichs (12) in diesem noch ein oberflächennaher weiterer Bereich zweiter Dotierung hoher Konzentration ausgebildet wird.
